# EUROPÄISCHE PATENTSCHRIFT

(11) **EP 2 539 933 B1**
(45) Veröffentlichungstag und Bekanntmachung des Hinweises auf die Patenterteilung: **17.02.2016**
(21) Anmeldenummer: 11708699.1
(22) Anmeldetag: 22.02.2011
(51) Int. Cl.: H01L 25/065, H01L 23/538, H01L 21/48

(54) **VERFAHREN ZUM HERSTELLEN EINES HALBLEITERMODULS**
METHOD FOR PRODUCING A SEMICONDUCTOR MODULE
PROCÉDÉ PERMETTANT DE FABRIQUER UN MODULE SEMI-CONDUCTEUR

(30) Priorität: 14.09.2010 DE 102010045372; 22.02.2010 DE 102010008789
(43) Veröffentlichungstag der Anmeldung: 02.01.2013
(73) Patentinhaber: Interposers GmbH, 80802 München (DE)
(72) Erfinder: Jakob, Andreas, 82319 Starnberg (DE); Kaiser, Thomas, 80331 München (DE)
(74) Vertreter: Zeuner Summerer Stütz
(86) Internationale Anmeldenummer: PCT/EP2011/000828
(87) Internationale Veröffentlichungsnummer: WO 2011/101170

(56) Entgegenhaltungen:
- EP-A1- 1 622 435
- US-A1- 2008 061 402

## Beschreibung

### Hintergrund der Erfindung

Die Erfindung betrifft ein Verfahren zum Herstellen eines Halbleitermoduls.

Mit der zunehmenden Bedeutung der mobilen Elektronik verlieren herkömmliche Leiterplatten mit den darauf zweidimensional angebrachten aktiven oder passiven Bauteilen, wie Halbleiterchips an Bedeutung. Die elektrischen oder elektronischen Bauteile werden dreidimensional gestapelt. Ziel ist es hierbei, innerhalb der Bauhöhe eines einzelnen Gehäuses, dem sogenannten Package, möglichst viele Chips in Form eines Stapels, in der Fachsprache auch "Stack" genannt, zu stapeln. Diese Technologie wird durch sehr dünne Wafer unterstützt, die immer besser herzustellen sind. Lagen die Materialstärken von gedünnten Wafern - und somit auch der einzelner Siliziumblättchen - in der Vergangenheit im Bereich von über 150 µm, so sind gegenwärtig Materialdicken von unter 50 µm möglich.

Diese Entwicklung entspricht auch jener Gesetzmäßigkeit, die als mooresches Gesetz bezeichnet wird, nach der die Elektronik bei Halbleitern einer stetigen Verkleinerung unterliegt. Die Herstellung und das Stapeln derartig dünner Chips ist eine konsequente Fortsetzung dieser Bemühungen, innerhalb eines einzelnen Halbleitermoduls möglichst viel Funktionalität auf möglichst kleiner Fläche unterzubringen. Hat man früher viel Funktionalität zweidimensional auf Platinen untergebracht, so wird nunmehr versucht, möglichst viele derartige Chips in einem möglichst kleinen Volumen - und somit dreidimensional - unterzubringen. Daher spricht der Fachmann von 3-dimensionaler Integration. Derartig dünne Chips wurden bisher gestapelt und mittels des klassischen Drahtbonden miteinander kontaktiert. Dabei wird ein dünner metallischer Draht zwischen den einzelnen Kontakten der Chips angebracht und somit die Chips elektrisch miteinander verbunden. Diese Form der Verkabelung hat sich jedoch als sehr umständlich und fehlerhaft erwiesen.

In der Folge gewann die Silizium-Durchkontaktierung, auch TSV-Prozess bezeichnet, an Bedeutung. Hierbei wird der dünne Wafer mittels durchgängigen Mikrolöchern zwischen den Schichten eines integrierten Schaltkreises, sogenannten Via's, welche als geätzte oder gebohrte Löcher ausgeführt sein können, perforiert. Diese Via's werden metallisch aufgefüllt und somit werden Kontakte von der Vorderseite zur Rückseite des Wafers und damit auch der resultierenden Chips erzeugt. Die Herausforderung besteht nun darin, von den Kontakten eines unteren Chips eine elektrische Kontaktierung zu den Kontakten der Rückseite eines darauf gestapelten Chips zu erzeugen. Gleichzeitig aber müssen hierbei die beiden Chips auf der übrigen Fläche voneinander elektrisch isoliert sein.

Anhand DRAM-Chips kann nachvollzogen werden, wie diese Aufgabenstellung gegenwärtig gelöst wird. Bei DRAM-Chips besteht das Verlangen, möglichst viel Speicherplatz in wenig Volumen zu erzeugen. Bei einigen Herstellern wird ein sogenannter Interposer - als eine Verdrahtungsebene - zwischen den zu stapelnden Bauteilen eingebracht. Erleichtert wird dieses dadurch, dass die Chips alle die gleiche Funktion und gleiche geometrische Auslegung haben. Per Design ist es somit möglich, dass sich die Kontaktfläche eines unten liegenden Chips positionsgenau dort befindet, wo auch die Kontaktfläche auf der Rückseite des oben liegenden Chips positioniert ist. Das jeweilige Gegenstück eines Kontaktes befindet sich also immer genau gegenüber, was die Kontaktierung erleichtert.

Als Interposer wird dabei vielfach auch ein gedünnter Wafer eingesetzt, der analog zu den Via's des TSV-Prozesses an den vorgesehenen Stellen durchkontaktiert ist und die Kontaktflächen beider Chips elektrisch miteinander verbindet. Dieser dünne Wafer wird dann zwischen den unteren und den oberen Wafer eingebracht und leitet die elektrischen Signale durch. Zum Zweck der besseren Kontaktierbarkeit kann hierbei auch entweder auf den Kontaktflächen des unteren und/oder auf der Rückseite des oberen Wafers eine metallische Erhöhung aufgebracht sein. Derartige Erhöhungen werden vom Fachmann auch als "Bumps" bezeichnet. Es ist aber auch möglich, diese Bumps auf eine oder beide Seiten des Interposers aufzubringen. Die Bumps sollen zum Zwecke der dauerhaften Kontaktierung vielfach auf die jeweils gegenüberliegende Kontaktfläche aufschmelzen und eine dauerhafte metallische Verbindung erzeugen. Die Kontaktierung mittels Bumps ist jedoch fehleranfällig. Die gewünschten elektrischen Kontaktierungen erfolgen oft nur in unzureichender Qualität. Weiterhin ist die thermische Kontaktierung zwischen den Halbleiterchips und dem Interposer für manche Anwendungen nicht optimal. Die Wärmeableitung von den Chips auf den Interposer kann über die Bumps oft nicht in ausreichender Weise sichergestellt werden.

Auch ist es möglich, eine Umverdrahtungslage direkt auf einen Halbleiterchip aufzudrucken, wie beispielsweise aus der US2008/0061402 bekannt ist.

Während es nach dem Stand der Technik relativ einfach ist, Bauteile gleicher Art und geometrischer Auslegung zu stapeln und miteinander zu kontaktieren, wird dieses mit unterschiedlichen Bauteilen sehr viel schwerer, weil diese gar nicht oder nur sehr unzureichend vom Design her dafür ausgelegt werden können. Mit der zunehmenden Anzahl unterschiedlicher Chips innerhalb eines Stacks wird dieses weiterhin zunehmend schwerer. Dabei treten auch zusätzliche Problematiken auf, weil Kontakte zwischen zwei unterschiedlichen Chips umverdrahtet werden müssen und sich hierbei auch Leitungen kreuzen können.

Durch einen Interposer nach dem Stand der Technik lässt sich dieses zum Teil dadurch lösen, als sich auf diesem dünnen Wafer auf beiden Seiten Leiterbahnen aufbringen lassen und somit relativ flexibel Kontakte geometrisch versetzen lassen. Dieses Verfahren ist aber sehr aufwendig und benötigt entsprechende lithografische Verfahren und somit zumeist auch teure Masken. Es kann daher nicht leicht angepasst werden und wird mit zunehmender Anzahl von übereinander gestapelten Chips sehr teuer. Aufgrund der hohen Maskenkosten kommt das Verfahren in der Regel nur für Halbleitermodule in Frage, die in großer Stückzahl hergestellt werden.

Problematisch ist weiterhin, dass hierbei immer ganze Wafer gestapelt werden müssen. Erst nach der Stapelung der Wafer werden diese durch Zersägen vereinzelt, um die einzelnen Halbleitermodule zu erhalten. Dies erschwert es zumindest Chips unterschiedlicher Art und Größe effizient zu stapeln. Es muss hierbei mit erheblichem Ausschuss gerechnet werden, was die Kosten pro funktionierendem Halbleitermodul in die Höhe treibt.

Aufgrund der derzeitigen Notwendigkeit zum Stapeln auf Waferebene werden gegenwärtig die Form und Größe der zu stapelnden Chips genau gleich konzipiert. Anderweitig wäre ein Trennen zum Beispiel mittels Sägen nicht mehr möglich, da hierbei zumindest ein Chip nicht mehr dem Sägemuster entsprechen würde.

Darüber hinaus ergeben sich Problematiken auf Grund der Tatsache, dass bei der Herstellung der Wafer die darauf befindlichen Chips nicht alle die gewünschten Eigenschaften besitzen und dabei vollkommen ausfallen oder nur eingeschränkte Funktionalität besitzen. Die Ausbeute auf einem Wafer ist also nun sehr selten 100%. Stapelt man nun zwei Wafer, deren Ausbeute jeweils unter 100 % ist, so ist es nahezu unvermeidlich, dass hierbei ein guter Chip über oder unter einem schlechten Chip platziert wird. Dadurch wird die Ausbeute guter Halbleitermodule wesentlich negativ beeinflusst.

### Zugrunde liegende Aufgabe

Es ist eine Aufgabe der Erfindung, ein Verfahren und eine Anordnung zum Herstellen eines Halbleitermoduls bereitzustellen, womit die vorgenannten Probleme gelöst werden, und insbesondere ein Halbleitermodul effizient und kostengünstig hergestellt werden kann. Die effiziente und kostengünstige Herstellung soll insbesondere für Halbleitermodule möglich sein, die in vergleichsweise geringer Stückzahl produziert werden.

### Erfindungsgemäße Lösung

Die vorgenannte Aufgabe kann erfindungsgemäß gelöst werden mit einem Verfahren nach Anspruch 1 zum Herstellen eines Halbleitermoduls mit mindestens zwei Halbleiterchips sowie einem Interposer. Der Interposer weist die Halbleiterchips miteinander verbindende, elektrisch leitende Strukturen auf. Bei dem erfindungsgemäßen Verfahren wird der Interposer direkt auf einen ersten der Halbleiterchips aufgedruckt. Beim Aufdrucken des Interposers werden die elektrisch leitenden Strukturen mittels elektrisch leitfähiger Tinte erzeugt. Darüber hinaus wird der zweite Halbleiterchip derart am Interposer montiert, dass die beiden Halbleiterchips übereinander angeordnet sind und der Interposer eine Zwischenschicht zwischen den beiden Halbleiterchips bildet.

Unter einem Halbleiterchip im Sinne der Anmeldung ist eine elektronische Schaltung zu verstehen, die mittels eines Halbleiterwerkstoffes, wie z.B. Silizium oder Galliumarsenid, gebildet wird. Beispielsweise beinhaltet ein derartiger Halbleiterchip pn-Übergänge. Im Gegensatz dazu bilden in Halbleitermodulen oft weiterhin enthaltene gedruckte Leiterplatten keine Halbleiterchips im Sinne der Anmeldung. Derartige Leiterplatten stellen elektrische Verbindungen zu den Halbleiterchips her und weisen wesentlich größere Strukturgrößen auf wie die zugeordneten Halbleiterchips. Unter einem Interposer im Sinne der Erfindung ist ein Bauteil zu verstehen, welches die Halbleiterchips elektrisch leitend miteinander verbindet. Im Stand der Technik werden oft auch Bauteile als Interposer bezeichnet, die eine Verbindung zwischen einen Halbleiterchip und einer Leiterplatte herstellen. Ein derartiger Interposer unterscheidet sich damit von der Funktionalität des erfindungsgemäßen Interposers.

Unter einer elektrisch leitfähigen Tinte im Sinne der Anmeldung wird ein Material verstanden, das im flüssigen oder pastenartigen Zustand auf eine zu bedruckende Fläche aufgebracht wird und danach, beispielsweise durch Laserbestrahlung oder Erwärmen, verfestigt wird. Das verfestigte Material ist elektrisch leitfähig. Beispiele für derartige elektrisch leitfähige Tinten umfassen sogenannte Nano-Tinten, die Silberpartikel enthalten.

Erfindungsgemäß wird der Interposer direkt auf den ersten Halbleiterchip, d.h. auf dessen Vorderseite oder Rückseite, aufgedruckt. Dabei werden die elektrisch leitenden Strukturen mittels elektrisch leitender Tinte erzeugt. Unter direktem Aufdrucken ist zu verstehen, dass der Interposer nicht zunächst auf eine von dem ersten Halbleiterchip separate Trägerschicht aufgedruckt wird, die dann wiederum auf den ersten Halbleiterchip aufgebracht wird. Vielmehr wird der Interposer unmittelbar auf den ersten Halbleiterchip aufgedruckt. Die zu bedruckende Oberfläche des ersten Halbleiterchips kann z.B. durch eine Passivierungsschicht gebildet werden. Das Aufdrucken des Interposers auf den ersten Halbleiterchip kann z.B. erfolgen, indem zunächst eine elektrisch isolierende Schicht und daraufhin die elektrisch leitenden Strukturen aufgedruckt werden. Alternativ können die elektrisch leitenden Strukturen auch direkt auf den ersten Halbleiterchip aufgedruckt werden. Durch das erfindungsgemäße direkte Aufdrucken des Interposers auf den Halbleiterchip müssen die Chips nicht mehr jeweils als Teil eines Wafers gestapelt werden, sondern können bereits vor dem Stapeln vereinzelt werden. Damit können beliebig große Chips übereinander gestapelt werden.

Ein direkt auf die Chipoberfläche oder deren jeweilige Rückseite gedruckter Interposer lässt es zu, dass nach dem Vereinzeln der Wafer die jeweiligen Chips individuell gehandhabt und sortiert werden können. Damit können die Chips entsprechend ihrer Eigenschaften mit anderen Chips gestapelt werden oder alternativ ausgesondert werden.

Durch das erfindungsgemäße drucktechnische Herstellen des Interposers sowie das Verwenden von elektrisch leitfähiger Tinte wird es möglich, auf sehr viel wirtschaftlichere Weise kleine Volumen an 3-dimensional integrierten Halbleitermodulen zu fertigen. Während es bei den Verfahren nach dem Stand der Technik notwendig ist, lithografische Verfahren zu nutzen und damit Maskensätze erforderlich sind, oder es bei Verwendung von Folien als Trägermaterial des Interposers notwendig ist, entsprechende Fertigungen anzupassen, benötigt der erfindungsgemäße gedruckte Interposer nur die Änderung eines Druckauftrages. Rechnet man bei den Verfahren nach dem Stand der Technik die Kosten pro Halbleitermodul, so ergeben sich bei abnehmender Anzahl dieser Module stark steigende Kosten pro Modul. Durch die Möglichkeit, per Druckauftrag die Auslegung des Interposers zu ändern, können schnell und wirtschaftlich Änderungen oder Anpassungen vorgenommen werden.

Gemäß einer Ausführungsform nach der Erfindung wird die elektrisch leitfähige Tinte zum Erzeugen der elektrisch leitenden Strukturen von einer Düse abgesondert. Insbesondere wird die elektrisch leitfähige Tinte mittels einer Düse auf die zu beschichtende Fläche aufgesprüht. Dabei kann ein Verfahren wie das Tintenstrahldrucken verwendet werden, bei dem die Tinte mittels kleiner Tröpfen aufgetragen wird. Gemäß einer erfindungsgemäßen Variante werden die elektrisch leitenden Strukturen mittels eines Aerosolstrahldruckverfahrens erzeugt. Besonders vorteilhaft ist aber das Aerosolstrahldruckverfahren in der Ausführungsform, wie es die Firma Optomec anbietet. Dabei wird durch eine Düse das zu druckende Material mittels Dauerstrahl aufgetragen. Gemäß einer alternativen Ausführungsform kann die elektrisch leitende Tinte mittels eines Siebdruckverfahrens auf die zu beschichtende Fläche gedruckt werden.

Gemäß einer weiteren Ausführungsform nach der Erfindung umfasst das Aufdrucken des Interposers auf den ersten Halbleiterchip ein Aufdrucken einer elektrisch isolierenden Schicht mit Aussparungen auf den Halbleiterchip und Aufsprühen der elektrisch leitfähigen Tinte mittels einer Düse auf die elektrisch leitende Schicht. Die elektrisch isolierende Schicht kann organisches und/oder anorganisches Material aufweisen und mit Füllstoffen und/oder Additiven angereichert sein. Vorzugsweise erfolgt eine Aushärtung der elektrisch isolierenden Schicht nach dem Drucken mittels aktinischer Strahlung, chemischer Reaktion, Wärme oder Trocknung. Aussparungen werden in der elektrisch isolierenden Schicht beispielsweise gebildet, indem an diesen Stellen das aufgebrachte Material nicht vernetzt und gezielt wieder entfernt wird. Gemäß einer erfindungsgemäßen Variante wird die isolierende Schicht so aufgebracht, dass sie die Topographie der Chipoberfläche einebnet oder glättet.

Gemäß einer weiteren Ausführungsform nach der Erfindung wird die elektrisch isolierende Schicht per Siebdruck auf den ersten Halbleiterchip aufgedruckt. Gemäß weiteren Ausführungsformen kann die isolierende Schicht auch per Rotationsbeschichtung, Sprühbeschichtung Dispensen und/oder mittels einer Düse aufgebracht werden.

Wie bereits vorstehend erwähnt wird gemäß einer Ausführungsform nach der Erfindung wird beim Aufdrucken des Interposers auf den ersten Halbleiterchip die elektrisch leitfähige Tinte mittels einer Düse unmittelbar auf den ersten Halbleiterchip aufgesprüht.

Gemäß einer weiteren Ausführungsform nach der Erfindung weist die elektrisch leitfähige Tinte metallische Partikel mit einer maximalen Abmessung von höchstens 20 nm auf. Mit anderen Worten weisen die metallischen Partikel eine Korngröße von höchstens 20 nm, insbesondere von höchstens 10 nm oder von höchstens 2 nm auf.

Gemäß einer weiteren Ausführungsform nach der Erfindung weist die elektrisch leitfähige Tinte Silber, Gold und/oder Kupferpartikel auf. Gemäß einer weiteren Ausführungsform weist die elektrisch leitfähige Tinte metallische Partikel auf, die sich bei einer Temperatur von unter 200 °C, insbesondere von unter 150 °C, verbinden, insbesondere vernetzen bzw. versintern. Seit einiger Zeit werden Tinten angeboten, die bei derart geringen Temperaturen ausgehärtet bzw. versintert werden können. Ein Beispiel für eine derartige Tinte ist die leitfähige Nano-Tinte Baylnk® TPS der Firma Bayer, die mit Silberpartikeln in Nanometergröße angereichert sind. Die sehr geringe Partikelgröße lässt es zu, dass derartige Tinten schon bei weit unter 200 °C gesintert werden können. Es sind Versuche bekannt, bei denen schon Temperaturen von ca. 140 °C ein Sintern ermöglichten. Mit einer Leitfähigkeit von 5000 S/m sind diese Materialien ausreichend leitfähig. Darüber hinaus bietet Bayer auch eine leitfähige Tinte Baylnk® CNT an, die mittels Nanoröhrchen angereichert sind und aussichtsreiche Eigenschaften besitzt. Abgesehen von silberhaltigen Tinten ist auch der Einsatz von Tinten sinnvoll, die Nanopartikel anderer Metalle, wie zum Beispiel Kupfer erhalten.

Gemäß einer weiteren Ausführungsform nach der Erfindung weist die elektrisch leitfähige Tinte metallische Partikel auf, die sich bei Einstrahlung von Licht mit einer Wellenlänge von weniger als 600 nm verbinden, insbesondere vernetzen bzw. versintern. Damit ist ein kurzwelliges Vernetzen bzw. Versintern mit Licht einer Wellenlänge von z.B. 523 nm oder 355 nm möglich.

Gemäß einer weiteren Ausführungsform nach der Erfindung ist der erste Halbleiterchip beim Aufdrucken des Interposers Teil eines Wafers. Der Wafer weist in der Regel eine Vielzahl von Halbleiterchips auf. Mit anderen Worten ist der erste Halbleiterchip beim Aufdrucken des Interposers noch nicht vereinzelt. Alternativ ist es allerdings auch möglich, den ersten Halbleiterchip bereits vor dem Aufdrucken des Interposers zu vereinzeln.

Gemäß einer weiteren Ausführungsform nach der Erfindung wird der Wafer vor dem Aufdrucken des Interposers auf fehlerhafte Bereiche getestet, und auf Grundlage des Testergebnisses wird das Layout der aufzudruckenden elektrisch leitenden Strukturen unter Vermeidung der fehlerhaften Bereiche konfiguriert. Gemäß einer weiteren Ausführungsform werden vor dem Aufdrucken des Interposers auch am Interposer zu montierende zweite Halbleiterchips auf fehlerhafte Bereiche getestet und dieses Testergebnis zur Bestimmung des Layouts der aufzudruckenden elektrisch leitenden Strukturen herangezogen. Dies erfolgt vorzugsweise, indem die elektrisch leitenden Strukturen funktionierende Bereiche der im fertigen Halbeitermodul aufeinander gestapelten Chips miteinander verdrahten. Fehlerhafte Bereiche werden dabei von den elektrisch leitenden Strukturen umgangen. Vorzugweise werden aufgrund des Testergebnisses Halbleiterchips, die derart fehlerhalft sind, dass sie als unbrauchbar erscheinen, vorab ausgemustert.

Erfindungsgemäß wird weiterhin ein Halbleitermodul bereitgestellt, welches mindestens zwei übereinander angeordnete Halbleiterchips, sowie einen zwischen den beiden Halbleiterchips angeordneten Interposer umfasst. Der Interposer weist die Halbleiterchips miteinander verbindende, elektrisch leitende Strukturen auf und ist als mindestens einlagige Druckschicht ausgebildet, die unmittelbar an einen ersten der Halbleiterchips angrenzt, wobei die elektrisch leitenden Strukturen aus elektrisch leitfähiger Tinte gebildet sind. Die elektrisch leitfähige Tinte liegt im fertigen Halbleitermodul in einem verfestigten bzw. vernetzten oder versinterten Zustand vor. Gemäß einer Ausführungsform des Halbleitermoduls ist die elektrisch leitfähige Tinte durch Absonderung mittels einer Düse erzeugt. Vorzugsweise weist die elektrisch leitfähige Tinte metallische Partikel mit einer maximalen Abmessung von höchstens 20 nm auf.

Erfindungsgemäß wird weiterhin ein Halbleitermodul bereitgestellt, welches mindestens zwei übereinander angeordnete Halbleiterchips, sowie einen zwischen den beiden Halbleiterchips angeordneten Interposer aufweist. Der Interposer umfasst elektrisch leitende Strukturen, welche die Halbleiterchips miteinander verbinden, wobei die elektrisch leitenden Strukturen metallische Partikel mit einer maximalen Abmessung von höchstens 20 nm, insbesondere mit einer maximalen Abmessung von höchstens 10 oder von höchstens 2 nm aufweisen. Derartige Strukturen können mittels einer sogenannten Nano-Tinte erzeugt werden. Die geringe Abmessung der metallischen Partikel ermöglicht es, die Partikel der Tinte bei relativ geringer Temperatur zu verbinden, d.h. die Tinte zu vernetzen bzw. zu sintern. Gemäß einer Ausführungsform weisen die elektrisch leitenden Strukturen metallische Partikel auf, die sich bei einer Temperatur von unter 150 °C verbinden. Damit wird ein Aufdrucken des Interposers direkt auf einen der Halbleiterchips wesentlich erleichtert, da durch die relativ geringe Vernetzungstemperatur die elektrischen Eigenschaften de Halbleiterchips nicht nachteilig beeinflusst werden. Gemäß einer weiteren Ausführungsform nach der Erfindung weisen die elektrisch leitenden Strukturen Silber, Gold und/oder Kupferpartikel auf. Gemäß einer weiteren Ausführungsform weisen die elektrisch leitenden Strukturen metallische Partikel auf, die sich bei Einstrahlung von Licht mit einer Wellenlänge von weniger als 600 nm verbinden, insbesondere vernetzen bzw. versintern.

Weiterhin wird erfindungsgemäß eine Anordnung zum Herstellen eines Halbleitermoduls mit mindestens zwei Halbleiterchips sowie einem Interposer bereitgestellt, welcher die Halbleiterchips miteinander verbindende, elektrisch leitende Strukturen aufweist. Die Anordnung umfasst eine Druckeinrichtung, welche dazu konfiguriert ist, einen Interposer auf einen ersten der Halbleiterchips aufzudrucken und dabei die elektrisch leitenden Strukturen mittels elektrisch leitfähiger Tinte zu erzeugen. Weiterhin umfasst die Anordnung eine Montageinrichtung, welche dazu konfiguriert ist, den zweiten Halbleiterchip derart am Interposer zu montieren, dass die beiden Halbleiterchips übereinander angeordnet sind und der Interposer eine Zwischenschicht zwischen den beiden Halbleiterchips bildet. Die Druckeinrichtung und die Montageeinrichtung können jeweils als separate Vorrichtungen ausgeführt sein. Alternativ können diese Einrichtung aber auch Module einer einzigen Vorrichtung sein.

Gemäß einer Ausführungsform der erfindungsgemäßen Anordnung umfasst die Druckeinrichtung eine erste Druckeinheit, welche dazu konfiguriert ist, eine elektrisch isolierende Schicht auf den Halbleiterchip aufzudrucken. Darüber hinaus weist die Anordnung eine zweite Druckeinheit auf, welche eine Düse zum Aufsprühen elektrisch leitfähiger Tinte auf die isolierende Schicht umfasst. Gemäß einer weiteren Ausführungsform weist die erfindungsgemäße Vorrichtug weiterhin eine Halteeinrichtung auf, welche dazu konfiguriert ist, den ersten Halbleiterchips zu Halten und vor dem Aufdrucken des Interposers auszurichten.

Die bezüglich der vorstehend aufgeführten Ausführungsformen des erfindungsgemäßen Verfahrens angegebenen Merkmale können entsprechend auf das erfindungsgemäße Halbleitermodul und die erfindungsgemäße Anordnung übertragen werden. Umgekehrt können die bezüglich der vorstehend ausgeführten Ausführungsformen des erfindungsgemäßen Halbleitermoduls bzw. der erfindungsgemäßen Anordnung angegebenen Merkmale entsprechend auf das erfindungsgemäße Verfahren bzw. auf das erfindungsgemäße Halbleitermodul übertragen werden.

### Kurzbeschreibung der Zeichnungen

Die vorstehenden, sowie weitere vorteilhafte Merkmale der Erfindung werden in der nachfolgenden detaillierten Beschreibung beispielhafter erfindungsgemäßer Ausführungsformen unter Bezugnahme auf die beigefügten schematischen Zeichnungen veranschaulicht. Es zeigt:
Fig. 1 eine Schnittansicht eines erfindungsgemäßen Halbleitermoduls mit vier übereinander angeordneten und mittels Interposern verbundenen Halbleiterchips,
Fig. 2 eine Schnittansicht einer ersten Funktionseinheit einer erfindungsgemäßen Anordnung zum Herstellen eines Halbleitermoduls,
Fig. 3 eine Schittansicht einer zweiten Funktionseinheit der erfindungsgemäßen Anordnung zum Herstellen eines Halbleitermoduls,
Fig. 4 eine Schnittansicht einer dritten Funktionseinheit der erfindungsgemäßen Anordnung zum Herstellen eines Halbleitermoduls,
Fig. 5 eine Draufsicht auf die Oberseite eines Halbleiterchips mit metallischen Kontaktflächen,
Fig. 6 den Halbleiterchip gemäß Fig. 5 mit einer auf dessen Oberseite aufgedruckten elektrisch isolierenden Schicht,
Fig. 7 die elektrisch isolierende Schicht gemäß Fig. 6 mit mittels elektrisch leitfähiger Tinte aufgefüllten Aussparungen,
Fig. 8 die elektrisch isolierende Schicht gemäß Fig. 7 mit darauf aufgedruckten elektrisch leitenden Strukturen,
Fig. 9 die Struktur gemäß Fig. 8 mit einer die elektrisch leitenden Strukturen einbettenden weiteren elektrisch isolierenden Schicht,
Fig. 10 die Struktur gemäß Fig. 9 mit weiteren, auf deren Oberfläche aufgebrachten elektrisch leitenden Strukturen,
Fig. 11 die Struktur gemäß Fig. 10 mit weiteren aufgebrachten elektrisch isolierenden Schichten sowie mittels elektrisch leitfähiger Tinte gebildeten Erhöhungen, sowie
Fig. 12 die Struktur gemäß Fig. 11 mit einem auf die Erhöhungen aufgebrachtem Kontaktmetall.

### Detaillierte Beschreibung erfindungsgemäßer Ausführungsbeispiele

In den nachstehend beschriebenen Ausführungsbeispielen sind funktionell oder strukturell einander ähnliche Elemente soweit wie möglich mit den gleichen oder ähnlichen Bezugszeichen versehen. Daher sollte zum Verständnis der Merkmale der einzelnen Elemente eines bestimmten Ausführungsbeispiels auf die Beschreibung anderer Ausführungsbeispiele oder die allgemeine Beschreibung der Erfindung Bezug genommen werden.

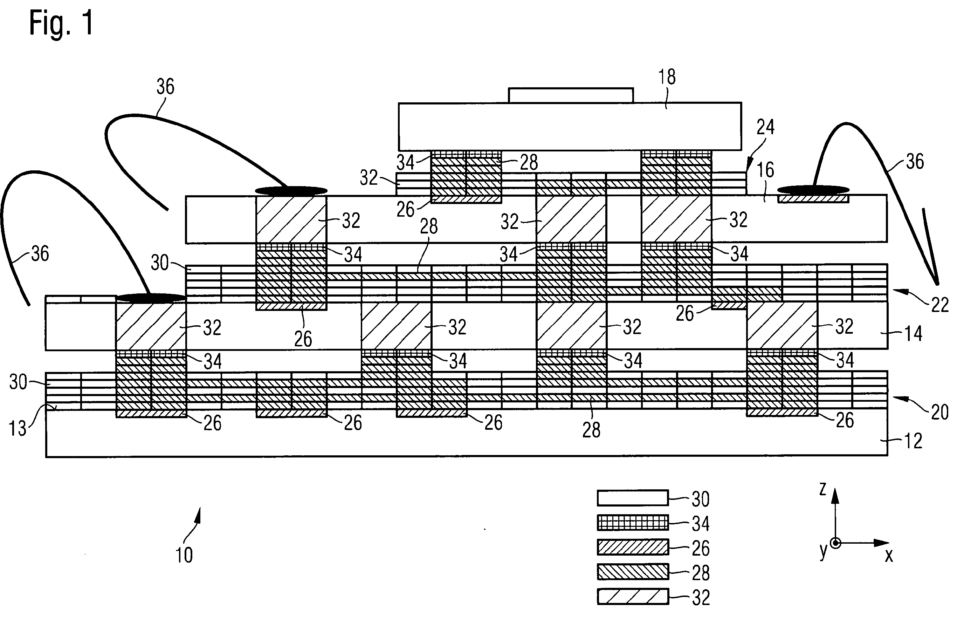

Zur Erleichterung der Beschreibung der Projektionsbelichtungsanlage ist in der Zeichnung ein kartesisches xyz-Koordinatensystem angegeben, aus dem sich die jeweilige Lagebeziehung der in den Figuren dargestellten Komponenten ergibt. In Fig. 1 verläuft die y-Richtung senkrecht zur Zeichenebene aus dieser heraus, die x-Richtung nach rechts und die z-Richtung nach oben.

Fig. 1 zeigt eine schematisch Veranschaulichung eines erfindungsgemäßen Halbleitermoduls 10 in Schnittansicht. Bei diesem handelt es sich um ein dreidimensional integriertes Modul, bei dem mehrere - im vorliegenden Fall vier Halbleiterchips 12, 14, 16 und 18 - übereinander gestapelt sind. Jeweils zwischen den Halbleiterchips sind sogenannte Interposer 20, 22 und 24 angeordnet. Die Interposer verbinden die jeweils angrenzenden Halbleiterchips elektrisch miteinander. Der Interposer 20 verbindet die Halbleiterchips 12 und 14, der Interposer 22 die Halbleiterchips 14 und 16 und der Interposer 24 die Halbleiterchips 16 und 18. Im veranschaulichten Beispiel ist der im Stapel ganz oben angeordnete Halbleiterchip 18 als Sensor ausgebildet, während die unterhalb angeordneten Halbleiterchips 16, 14 und 12 diverse integrierte Schaltkreise beinhalten.

Der Interposer 20 zwischen den Halbleiterchips 12 und 14 weist elektrisch leitende Strukturen 28 auf, die in ein elektrisch isolierendes Material 30 eingebettet sind. Sowohl das elektrisch isolierende Material 30 als auch die elektrisch leitenden Strukturen 28 werden erfindungsgemäß direkt auf eine Oberseite 13 des Halbleiterchips 12 aufgedruckt, wie nachstehend im Detail beschrieben. Die elektrisch leitenden Strukturen 28 werden mittels elektrisch leitfähiger Tinte gebildet und kontaktieren metallische Kontaktflächen 26 auf der Oberseite 13 des Halbleiterchips 12. An der Oberseite des Interposers 20 sind die elektrisch leitenden Strukturen 28 an mehreren Stellen mit Erhöhungen aus Kontaktmetall 34, sogenannten Bumps versehen. Diese Bumps kontaktieren den zweiten Halbleiterchip 14 von dessen Unterseite her an metallisch gefüllten Mikrolöchern in Gestalt von sogenannten Via's 32. Die gefüllten Via's 32 durchsetzen den Halbleiterchip 14 in seiner gesamten Dicke. Die einzelnen Via's sind an deren Oberseite entweder jeweils mit einem Bondingdraht 36 oder elektrisch leitenden Strukturen 28 des Interposers 22 kontaktiert. Der Aufbau der Interposer 22 und 24 ist analog zu dem soeben beschriebenen Aufbau des Interposers 20.

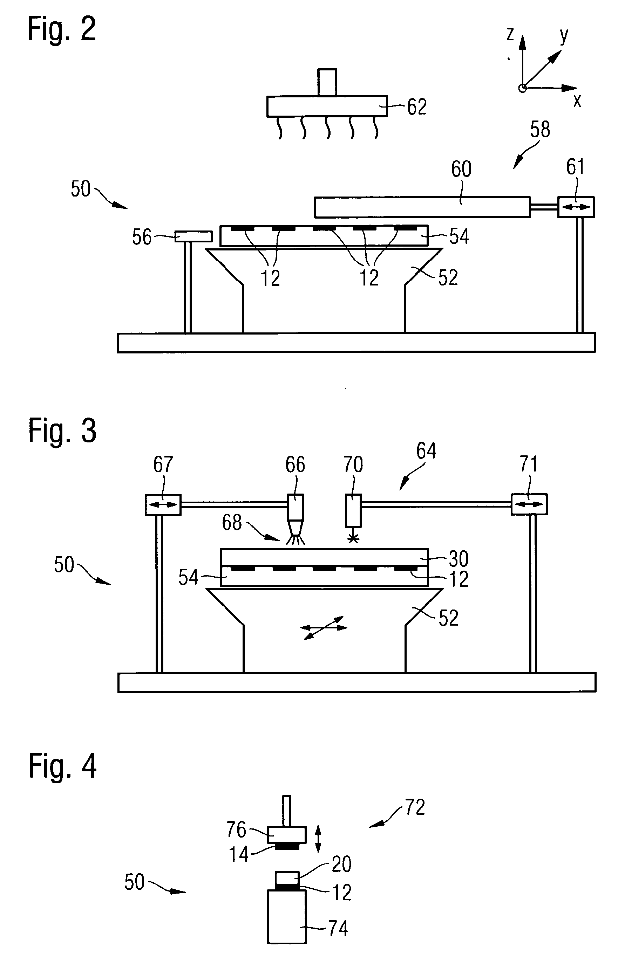

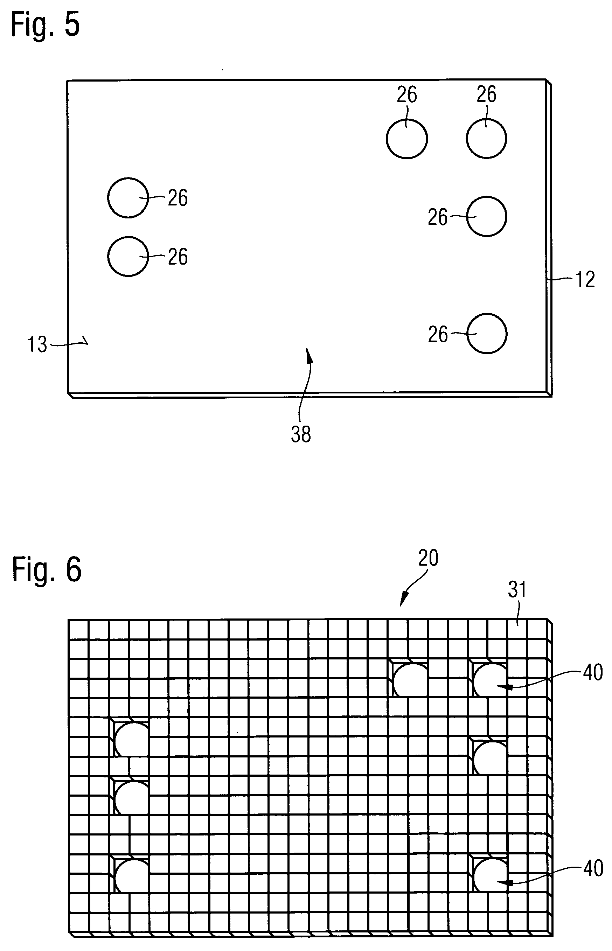

Die Figuren 5 bis 12 veranschaulichen im Detail das Aufbringen des Interposers 20 auf die Oberseite 13 des Halbleiterchips 12 in einer erfindungsgemäßen Ausführungsform. Die Figuren 2 bis 4 veranschaulichen eine dazu verwendete Anordnung 50 zum Herstellen eines Halbleitermoduls in einer erfindungsgemäßen Ausführungsform. Die erfindungsgemäße Anordnung 10 umfasst eine in Fig. 2 dargestellte erste Druckeinheit 58, eine in Fig. 3 dargestellte zweite Druckeinheinheit 64, sowie eine in Fig. 4 dargestellte Montageeinrichtung 72. Die genannten Funktionseinheiten können teilweise oder komplett in einer einzigen Vorrichtung integriert sein oder aber auch jeweils als separate Anlagen konzipiert sein.

Wie in Fig. 2 dargestellt, umfasst die Anordnung 50 eine Waferhalteeinrichtung 52 zum Halten eines Wafers 54, welcher eine Vielzahl Halbleiterchips 12 umfasst. Gemäß der veranschaulichten Ausführungsform werden die Halbleiterchips 12 ohne vorherige Vereinzelung, d.h. als Teil des Wafers 54 verarbeitet. Der Wafer 54 wird zunächst mittels eines Waferausrichters 56 zentral auf der Waferhalteeinrichtung 52 ausgerichtet. Wie in Fig. 5 gezeigt, weisen die einzelnen Halbleiterchips 12 auf ihren Oberseiten 13 eine Passivierungsschicht 38 sowie mehrere, die Passivierungsschicht 38 durchstoßende, kreisförmige metallische Kontaktflächen 26 auf.

In einem ersten Schritt des Herstellungsverfahrens in einer erfindungsgemäßen Ausführungsform wird eine Schicht 31 aus elektrisch isolierendem Material 30 in Gestalt eines Dielektrikums per Siebdruckverfahren direkt auf die Oberseite 13 des Halbleiterchips 12, d.h. auf die Passivierungschicht 38, aufgedruckt. Der Druck erfolgt dabei derart, dass die elektrisch isolierende Schicht 31 im Bereich der Kontaktflächen 26 Aussparungen 40 aufweist. Zum Aufdrucken der Schicht 31 wird in der Anordnung 10 eine in Fig. 2 veranschaulichte Druckmaske 60 mittels einer Verschiebeeinrichtung 61 über den Wafer 54 geschoben. Nach erfolgtem Siebdruck wird das gedruckte Material durch Einstrahlung von UV-Licht oder Wärme vernetzt. Dazu weist die Anordnung 50 eine entsprechende Strahlungsquelle 62 auf.

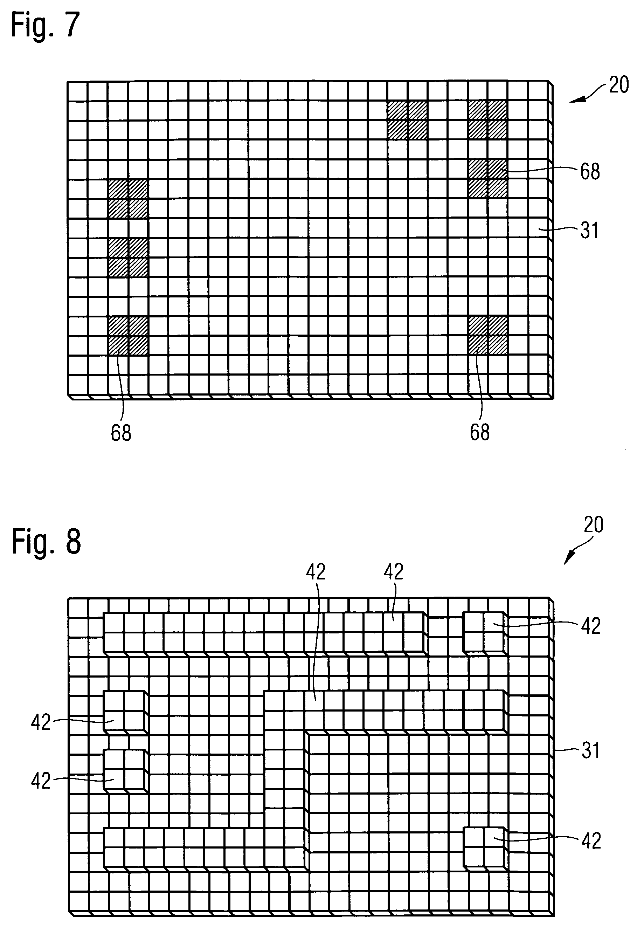

Daraufhin werden die Aussparungen 40 mittels leitfähiger Tine 68 aufgefüllt, wie in Fig. 7 dargestellt. Weiterhin werden einen Teil der elektrisch leitenden Strukturen 28 bildende Leiterbahnen 42 auf die elektrisch isolierende Schicht 31 aufgedruckt, wie in Fig. 8 dargestellt. Dies erfolgt mittels der in Fig. 3 dargestellten zweiten Druckeinheit 64. Diese umfasst eine Düse 66 zum Absondern der leitfähigen Tinte 68, beispielsweise mittels eines Aerosoldruckverfahrens. Dabei wird die leitfähige Tine mittels eines Dauerstrahls auf die isolierende Schicht 31 aufgetragen. Die elektrisch leitfähige Tinte 68 kann unterschiedlich konfiguriert sein, wie im allgemeinen Teil der Beschreibung aufgeführt. Gemäß einer Ausführungsform weist die Tinte 68 Silberpartikel in Nanometergröße auf. Nach dem Auftragen der Tinte 68 wird diese mit Licht des Lasers 70 zur Vernetzung bzw. Versinterung der Silberpartikel bestrahlt. Alternativ kann die leitfähige Tinte 68 auch per Siebdruckverfahren auf die isolierende Schicht 31 aufgebracht werden.

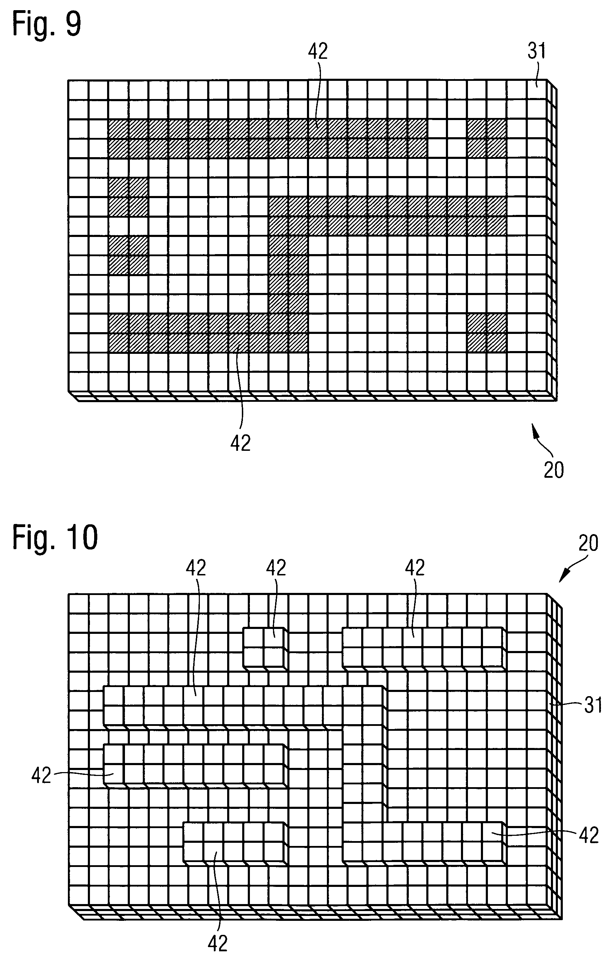

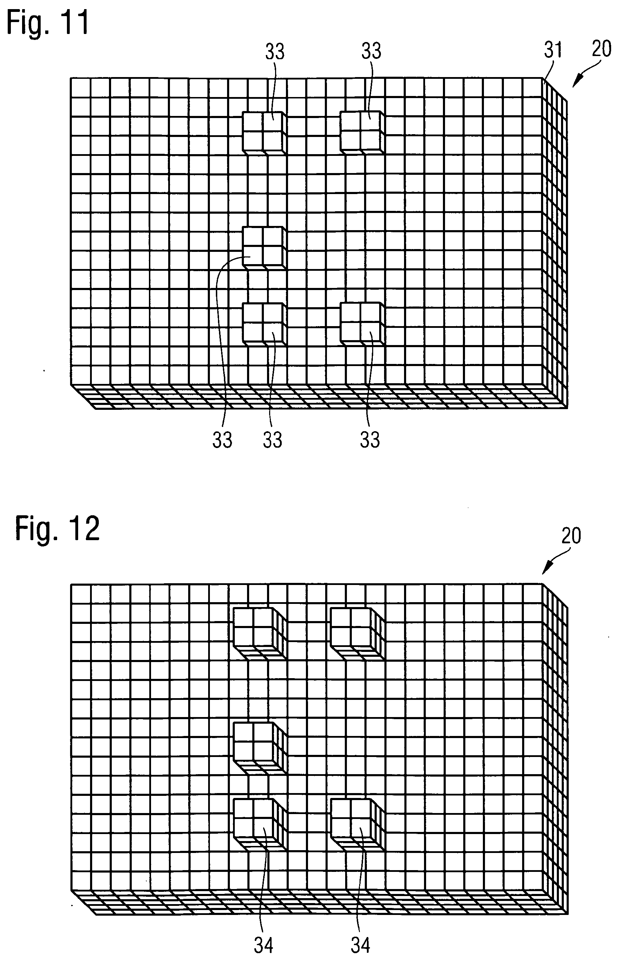

Wie in Fig. 9 dargestellt, werden daraufhin die Leiterbahnen 42 in einer weiteren elektrisch isolierende Schicht 31 eingebettet. Es folgen weitere Druckvorgänge, in denen weitere elektrisch isolierende Schichten 31 sowie weitere Leiterbahnen 42 erzeugt werden, wie in den Figuren 10 und 11 dargestellt. Als abschließende Herstellungsschritte werden metallische Erhöhungen 33 mittels leitfähiger Tinte 68 gedruckt. Auf diese Erhöhungen wird das Kontaktmetall 34 zur Ausbildung der vorstehend erwähnten Bumps aufgebracht, wie in Fig. 12 veranschaulicht.

Die Weiterverarbeitung des Wafers 54 mit dem darauf angeordneten Interposer 20 aus Fig. 12 kann auf unterschiedliche Arten erfolgen. Gemäß einer ersten Ausführungsform wird nun der Wafer 54 in durch Zersägen in die einzelnen Halbleiterchips 12 vereinzelt. Daraufhin werden die Halbleiterchips 12 einzeln auf einer Chiphaltevorrichtung 74 gemäß Fig. 4 angeordnet und der Halbleiterchip 14 mittels einer Chipplazierungsvorrichtung 76 derart auf dem Interposer 20 plaziert, dass entsprechende Kontaktflächen auf der Unterseite des Chips 14 die Kontaktmetalle 34 des Interposers 20 kontaktieren. In der Folge werden die weiteren Interposer 22 und 24 sowie die weiteren Halbleiterchips 16 und 18 analog zum vorstehend beschriebenen Verfahren aufgebracht und somit das Halbleitermodul 10 fertiggestellt.

In einer erfindungsgemäßen Ausführungsform werden vor der dreidimensionalen Integration des Halbleitermoduls die einzelnen Halbleiterchips 12, 14, 16 und 18 auf ihre elektrischen Eigenschaften getestet. Das Testergebnis liefert genaue Informationen zu fehlerhaften Bereichen auf den Chips. Die Testergebnisse werden einerseits verwendet, um stark fehlerhafte Chips vollständig auszusondern, und andererseits, um das Layout der elektrisch leitenden Strukturen 28 innerhalb der Interposer 20, 22 und 24 auf geeignete Weise zu konfigurieren. Dies geschieht derart, dass fehlerhafte Bereiche der Chips von der elektrischen Kontaktierung ausgenommen werden. So kann beispielsweise von einer Leitungsverbindung zwischen zwei direkt übereinander liegenden Chipsegmenten abgewichen werden, falls eines dieser Segmente fehlerhaft ist, und vielmehr die Leitungsverbindung zu einem benachbarten Segment des fehlerhaften Segments geführt werden.

Gemäß einer weiteren Ausführungsform wird der Wafer 54 mit dem darauf aufgedruckten Interposer 20 zunächst nicht vereinzelt. Vielmehr wird ein weiterer die Chips 14 enthaltender Wafer darauf platziert, so dass die entsprechenden Kontaktflächen auf der Unterseite der Chips 14 die Kontaktmetalle 34 des Interposers 20 kontaktieren. Das Aufdrucken des Interposers 22 erfolgt dann vollflächig über den gesamten Wafer. Die weiteren Chips 16 und 18 sowie der Interposer 24 können daraufhin ebenfalls vollflächig aufgebracht werden. Erst danach erfolgt die Vereinzelung durch Zersägen des Waferstapels. Auch in diesem Fall werden die elektrisch leitenden Strukturen 28 an die elektrischen Testergebnisse der Chips angepasst.

Im Folgenden werden weitere beispielhafte Ausführungsbeispiele der Erfindung beschrieben. Manche der Ausführungsbeispiele beschreiben vorstehend veranschaulichte Ausführungsformen mit anderen Worten, andere Ausführungsbeispiele ergänzen bzw. erweitern diese.

Das erfindungsgemäße Verfahren soll es erleichtern, bei der 3D-Integration von elektronischen Bauteilen (Chips) diese zu Stacks zu stapeln und elektrisch miteinander zu kontaktieren. Das Verfahren ermöglicht hierbei eine oder mehrere Verdrahtungsebenen, die als Interposer bezeichnet werden. Hierbei werden gemäß einer Ausführungsform mindestens zwei unterschiedliche Komponenten vorzugweise drucktechnisch aufgebracht. Dabei übernimmt eine Komponente die Funktion einer dielektrischen Schicht und die andere Komponente die Funktion eines elektrischen Leiters. Durch gezielte Steuerung eines Druckers ist es möglich, den Interposer drucktechnisch so aufzubauen, dass die Kontakte zweier unterschiedlicher Chips flexibel und individuell miteinander kontaktiert werden können.

Das nachfolgende Verfahren verzichtet weitgehend auf lithografische Prozesse. Es kann sowohl auf ganzen Wafern, wie auch auf bereits vereinzelten Chips oder einer Kombination hiervon angewendet werden.

Ausgehend von der Oberfläche eines fertig prozessierten Chips, der hierbei noch im Verbund eines nicht vereinzelten Wafers vorliegen kann oder der bereits vereinzelt ist, wird nun dieser Wafer oder Chip in einer Vorrichtung optisch erkannt und mechanisch ausgerichtet. Auf der Oberfläche des Chips befinden sich Flächen, die zum Zwecke der darunter liegenden Strukturen meistens mit einer geeigneten Schicht geschützt sind - der Fachmann spricht davon, dass diese passiviert sind. Darüber hinaus befinden sich auf dem Chip Flächen, die zum Zwecke der späteren Kontaktierbarkeit offen sind - deren zumeist metallische Oberfläche bewusst nicht isoliert wurde.

In der gleichen Vorrichtung, die den Wafer oder den bereits vereinzelten Chip ausgerichtet hat, befinden sich gemäß einer Ausführungsform zumindest zwei Druckköpfe, die einzeln angesteuert werden können. Diese Druckköpfe können aber auch Düsen sein oder andere Vorrichtungen, die dem gezielten und lokalem Auftrag von Material mit niedriger oder hoher Viskosität dienen, wie beispielsweise Siebdruckgeräte.

Nunmehr wird der erste Druckkopf in Funktion gesetzt. Er fährt nun jene Bereiche ab, die weiterhin isoliert bleiben sollen und druckt eine Flüssigkeit auf. Diese Flüssigkeit kann im Anwendungsfall ein Polyamid, ein Lack oder ein Harz oder eine andere organische oder anorganische Materie sein und ist - so notwendig - mit Zuschlagstoffen, Additiven oder anderer geeigneter Beimischungen angereichert worden, um sie hinsichtlich ihrer Viskosität und/oder ihrer späteren dielektrischen, mechanischen und geometrischen Eigenschaften zu optimieren. Mittels geeigneter Methode wird nun diese Flüssigkeit zu einer Schicht vernetzt oder ausgehärtet, die dielektrische Eigenschaften besitzt. Dabei kann diese Methode darin bestehen, die aufgedruckte Materie mittels energetischer Strahlung in Form von Licht, z.B. einer Lampe oder einem Laser auszuhärten. Dem Fachmann sind Verfahren bekannt, bei dem Lacke mittels UV-Licht vernetzt werden. Durch das zeitnahe Vernetzten, Trocknen oder anderweitiges Verfestigen oder Aushärten der aufgedruckten Flüssigkeit soll diese daran gehindert werden, unerwünscht zu verlaufen. Durch geeignete Ansteuerung des Druckkopfes, wie zum Beispiel seiner Vorwärtsgeschwindigkeit, seiner Druckfrequenz oder Druckmenge kann dieser auch dazu benutzt werden, die Topografie der Oberfläche des Chips - und somit auch die eines Wafers gezielt einzuebnen oder zu glätten. Somit lassen sich Vertiefungen in der Oberfläche eines Chips gezielt auffüllen.

Die heutigen Drucktechniken lassen eine weite Bandbreite von unterschiedlicher Viskosität zu, so dass auch pastöse Materialien gedruckt werden können.

Nachdem nunmehr der erste Druckkopf die Flüssigkeit aufgedruckt hat und diese geeignet vernetzt, getrocknet oder anderweitig verfestigt oder ausgehärtet wurde, verbleibt eine dielektrische Schicht, die punktuell Aussparungen hat, welche zum Zwecke der Kontaktierung des Chips bzw. des Wafers dienen.

Nunmehr wird ein zweiter Druckkopf in Funktion gesetzt, der eine metallisch angereicherte oder gefüllte Flüssigkeit druckt, welche auch als elektrisch leitfähige Tinte bezeichnet wird. Auch diese Tinte kann zum Zwecke ihrer Viskosität und der späteren mechanischen, elektrischen oder topographischen Eigenschaften gezielt mit Zuschlagsstoffen und Additiven angereichert sein.

Der Drucker mit der metallischen Tinte steuert nun gezielt die Flächen an, die nicht mit dem dielektrischem Material bedruckt wurden. Mittels geeigneten Verfahren wird nun diese Tinte so behandelt, dass sie aushärtet und eine gute elektrische Verbindung zu den metallischen Kontaktflächen sicher gestellt ist. Dabei kann es sich um Verfahren handeln, welche durch eine Trocknung die Tinte verfestigt, indem zum Beispiel Lösungsmittel oder Wasser entweicht. Es ist aber auch möglich, diese Tinte mittels Laser oder anderer geeigneter energetischer und/oder thermischer Verfahren zu sintern oder zu verschmelzen. Dabei ist es nicht zwingend notwendig, dass die geometrischen Eigenschaften des somit gedruckten Metalls dem der aufgebrachten dielektrischen Schicht ähnlich sind. Durch gezielte Ansteuerung des Druckkopfes kann das Druckergebnis auch über Druckgeschwindigkeit oder Druckkopfeinstellung optimiert und angepasst werden, so dass sich das Druckergebnis beider Materialien geometrisch ergänzt.

Gemäß einer Ausführungsform kann auch diese erste gedruckte Schicht aus Metall zuerst mit einem anderen Druckkopf aufgebracht werden, der eine metallische Tinte druckt, die besser kontaktierbar und/oder aufschmelzbar ist, wodurch die metallische Verbindung zu den Kontaktflächen erleichtert oder verbessert wird, und erst darauffolgend mit einer anderen metallischen Tinte gedruckt werden.

Nachdem nun auf den Kontakten des Wafers oder des Chips eine erste metallische Lage aufgebracht worden ist, druckt der Druckkopf eine oder weitere Lagen auf, die geeignet getrocknet, gesintert, vernetzt oder anderweitig verfestigt oder ausgehärtet werden. Darüber hinaus druckt er nun auch Leiterbahnen, die der späteren Umverdrahtung dienen. Dabei wird der Druckkopf ein- oder mehrfach so geführt, dass eine Leiterbahn entsteht. Diese Leiterbahn wird bezüglich ihrer geometrischen Auslegung, der Breite, Höhe und Querschnitt den gesetzten Anforderungen entsprechen. Ebenso hinsichtlich den elektrischen Eigenschaften, Leitfähigkeit und ohmscher Widerstand.

Im Wechselspiel beider Druckköpfe lassen sich nun eine oder mehrere Verdrahtungsebenen aufbauen. Dabei kann es auch möglich sein, dass beide Druckköpfe zeitgleich oder zeitlich versetzt ihr zu druckendes Material aufbringen und vernetzen bzw. versintern.

Durch das Zusammenspiel beider Druckköpfe ist es so möglich, dass die verschiedenen Verdrahtungen so geführt werden, dass sie sich kreuzen und dennoch untereinander durch die gedruckte dielektrische Schicht voneinander isoliert sind.

Als Resultat entsteht ein dreidimensionaler Interposer, der größtenteils aus dielektrischem Material besteht und in dem die elektrischen Verdrahtungen eingefasst sind.

Bekannt sind Verfahren, bei denen drucktechnisch zumeist passive elektronische Bauteile wie elektrische Widerstände oder Kapazitäten gedruckt werden. Innerhalb des Schichtverbundes lassen sich mit einer solchen Methode derartige Bauteile drucken. Dabei werden die mit dem leitenden Material erzeugten Leiterbahnen derartige Bauteile kontaktieren. Mit der Methode ist es somit auch möglich, derartige Bauteile zwischen zwei Chips zu implementieren oder auch die elektrische Funktion eines einzelnen Chips zu ergänzen indem ein solches Bauelement zwischen zwei Kontakten eines einzelnen Chips implementiert wird.

Zum Zwecke der elektrischen Kontaktierung der Kontakte auf der Rückseite des oben aufliegenden Wafers oder Chips ist es mittels des Druckkopfes möglich, für die metallische Tinte eine Erhebung aus Metall zu erzeugen, die dem Zweck und in der Form einem klassischen sogenannten "Bump" sehr nahe kommt. Hierzu druckt der Druckkopf mehrfach Lagen übereinander, bis eine geeignete Erhöhung erreicht ist, die eine elektrische Kontaktierung zu den Kontakten auf der Rückseite des darüber liegenden Wafers oder Chips erleichtert.

Es ist darüber hinaus möglich, dass ein dritter Druckkopf eine zweite metallisch gefüllte Tinte auf die Erhöhung druckt, die hinsichtlich ihrer thermischen oder sonstigen Eigenschaft eine Kontaktierung zu den Kontaktflächen auf der Rückseite erleichtert. Somit entsteht auf dem Bump ein metallischer Überzug, der sich leichter aufschmelzen lassen würde.

Ein Vorteil der Erfindung liegt in der Tatsache, dass auf lithografische Verfahren verzichtet werden kann und somit auch keine teuer und aufwendig herzustellenden Masken verwendet werden müssen. Insbesondere bei der Produktion kleiner Serien oder Einzelanfertigungen sind gegenüber den üblichen Verfahren deutliche Kostenvorteile zu erwarten. Dabei ist die Tatsache, dass der Aufbau des Interposers alleinig über die Druckeransteuerung erfolgt ein besonderer Vorteil, da eine Anpassung und Umsetzung der Erfordernisse allein auf der Änderung von Dateien beruht, in denen das jeweilige Schema des Interposers abgelegt ist.

Ein weiterer Vorteil liegt darin, dass bereits vereinzelte Bauelemente (Chips) verarbeitet werden können. Dieses war bisher nur sehr unzulänglich möglich, da die üblichen lithografischen Verfahren bisher meistens nur auf nicht vereinzelten Wafer anwendbar waren.

Die flexible Gestaltung des Interposers macht es zudem möglich, sehr viel einfacher Bauelemente (Chips) unterschiedlichster Größe, geometrischer Auslegung und Funktion miteinander zu verbinden und innerhalb der resultierenden Stacks eine anpassungsfähige Verdrahtung zu gewährleisten. Ein weiterer Vorteil liegt darin, dass innerhalb des Interposers auch passive Bauelemente eingebracht werden können.

Ein bereits aus einem Wafer gesägter und somit vereinzelter Chip (HalbleiterBauelement) soll mit einem weiteren vereinzelten Chip gestapelt werden und elektrisch kontaktiert werden. Bei den beiden Chips handelt es sich um Bauteile, die unterschiedliche Funktionen besitzen und deren geometrisches Design unterschiedlich ist. Zumindest der oben liegende Chip ist wesentlich gedünnt worden und besitzt zum Zwecke der elektrischen Signalführung Kontakte auf der Chiprückseite die mittels metallisch aufgefüllter Löcher (sogenannte Vias) im Chip eine Kontaktierung von der Vorderseite des Chips zu seiner Rückseite ermöglichen.

Der unten liegende Chip wird vorderseitig mittels einer optischen Erkennung innerhalb einer Druckeinrichtung ausgerichtet. Nunmehr beginnt ein Druckkopf einen Lack aufzutragen, der innerhalb einer Sekunde mittels eines zum Druckkopf synchron geführten Lichtstrahls mit einem hohen UV-Anteil vernetzt wird. Mittels des Lichtes wird dabei der zuvor aufgebrachte Lack so vernetzt, dass eine Umwandlung zu einem festen Material erfolgt, das dielektrische Eigenschaften besitzt.

Mittels Führen des Druckerkopfes und des synchron geführten Lichtstrahls wird nunmehr auf dem Bauteil eine Schicht mit dielektrischer Eigenschaft erzeugt, die an vorher bestimmten Stellen Aussparungen besitzt, bei denen diese Schicht nicht aufgebracht wird. An diesen Stellen befinden sich Kontaktflächen des Chips, die zum Zwecke der Kontaktierung frei gehalten werden.

Im Anschluß bringt ein weiterer Druckkopf eine metallisch gefüllte Flüssigkeit (metallisch gefüllte Tinte) nunmehr gezielt in jene freie Stellen auf, die zuvor bei der Herstellung der dielektrischen Schicht ausgespart und somit frei gehalten worden sind. Hierbei wird ein Laser synchron geführt, der diesmal mittels seiner Energie die metallische Füllung der Flüssigkeit vernetzt, bzw. sintert.

Nachdem die offenen Kontakte mittels der metallischen Tinte aufgefüllt worden sind, wird der Druckkopf nun so gesteuert, dass Leiterbahnen erzeugt werden. Mittels geeigneter Ansteuerung beider Druckköpfe wird nun ein Interposer aufgebaut, der die in ihm enthaltenden Leiterbahnen so führt, dass die gewünschte elektrische Kontaktierung beider Chips erfolgt. Dabei werden die Leiterbahnen in das isolierende Material so eingebettet, dass eine unerwünschte Kontaktierung dieser untereinander oder zu den jeweiligen Chips unterbleibt.

### Bezugszeichenliste

- 10: Halbleitermodul
- 12: Halbleiterchip
- 13: Oberseite
- 14: Halbleiterchip
- 16: Halbleiterchip
- 18: Halbleiterchip
- 20: Interposer
- 22: Interposer
- 24: Interposer
- 26: metallische Kontaktfläche
- 28: elektrisch leitende Strukturen
- 30: elektrisch isolierendes Material
- 31: elektrisch isolierende Schicht
- 32: gefülltes Via
- 33: metallische Erhöhung
- 34: Kontaktmetall
- 36: Bondingdraht
- 38: Passivierungsschicht
- 40: Aussparung
- 42: Leiterbahn
- 50: Anordnung zum Herstellen eines Halbleitermoduls
- 52: Waferhalteeinrichtung
- 54: Wafer
- 56: Waferausrichter
- 58: erste Druckeinheit
- 60: Druckmaske
- 61: Verschiebeeinrichtung
- 62: Strahlungsquelle
- 64: zweite Druckeinheit
- 66: Düse
- 67: Verschiebeeinrichtung
- 68: elektrisch leitfähige Tinte
- 70: Laser
- 71: Verschiebeeinrichtung
- 72: Montageeinrichtung
- 74: Chiphaltevorrichtung
- 76: Chipplatzierungsvorrichtung

## Patentansprüche

1. Verfahren zum Herstellen eines Halbleitermoduls (10) mit mindestens zwei Halbleiterchips (12, 16, 18) sowie einem Interposer (20, 22, 24), welcher die Halbleiterchips miteinander verbindende, elektrisch leitende Strukturen (28) aufweist, bei dem:
- der Interposer direkt auf einen ersten der Halbleiterchips aufgedruckt wird,
- beim Aufdrucken des Interposers die elektrisch leitenden Strukturen mittels elektrisch leitfähiger Tinte (68) erzeugt werden,
- beim Aufdrucken des Interposers eine elektrisch isolierende Schicht (31) mit Aussparungen (40) unmittelbar auf den ersten Halbleiterchip per Siebdruck aufgedruckt wird, und das Erzeugen der elektrisch leitenden Strukturen umfasst: Auffüllen der Aussparungen mittels der elektrisch leitfähigen Tinte und daraufhin erfolgendes Erzeugen von Leiterbahnen durch Auftragen der elektrisch leitfähigen Tinte auf die elektrisch isolierende Schicht, wobei die elektrisch leitfähige Tinte jeweils mittels eines Aerosolstrahldruckverfahrens abgesondert wird, sowie
- der zweite Halbleiterchip derart am Interposer montiert wird, dass die beiden Halbleiterchips übereinander angeordnet sind und der Interposer eine Zwischenschicht zwischen den beiden Halbleiterchips bildet.

2. Verfahren nach Anspruch 1,
bei dem der erste Halbleiterchip beim Aufdrucken des Interposers Teil eines Wafers (54) ist.

3. Verfahren nach Anspruch 2,
bei dem der Wafer vor dem Aufdrucken des Interposers auf fehlerhafte Bereiche getestet wird und auf Grundlage des Testergebnisses das Layout der aufzudruckenden elektrisch leitenden Strukturen unter Vermeidung der fehlerhaften Bereiche konfiguriert wird.

4. Verfahren nach einem der vorausgehenden Ansprüche,
bei dem die elektrisch leitfähige Tinte metallische Partikel mit einer maximalen Abmessung von höchstens 20 nm aufweist.

5. Verfahren nach einem der vorausgehenden Ansprüche,
bei dem die elektrisch leitfähige Tinte Silber, Gold und/oder Kupferpartikel aufweist.

6. Verfahren nach einem der vorausgehenden Ansprüche,
bei dem die elektrisch leitfähige Tinte metallische Partikel aufweist, die sich bei einer Temperatur von unter 200 °C verbinden.

7. Verfahren nach einem der vorausgehenden Ansprüche,
bei dem die elektrisch leitfähige Tinte metallische Partikel aufweist, die sich bei Einstrahlung von Licht mit einer Wellenlänge von weniger als 600 nm verbinden.

8. Verfahren nach einem der Ansprüche 2 bis 7,
bei dem der Wafer nach dem Aufdrucken des Interposers vereinzelt wird.

## Claims

1. A method of producing a semi-conductor module (10) comprising at least two semi-conductor chips (12, 16, 18) and an interposer (20, 22, 24) which has electrically conductive structures (28) connecting the semi-conductor chips to one another, wherein:
- the interposer is printed directly onto a first of the semi-conductor chips,
- when the interposer is printed on, the electrically conductive structures are produced by means of electrically conductive ink (68), and
- when the interposer is printed on an electrically insulating layer (31) with openings (40) is printed directly onto the first semi-conductor chip by screen printing, and producing the electrically conductive structures includes: filling the openings with electrically conductive ink and then producing conductor paths by applying the electrically conductive ink to the electrically insulating layer, the electrically conductive ink respectively being discharged by means of an aerosol jet printing method, and
- the second semi-conductor chip is mounted on the interposer such that the two semi-conductor chips are arranged one above the other and that the interposer forms an intermediate layer between the two semi-conductor chips.

2. The method according to Claim 1,
wherein the first semi-conductor chip is part of a wafer (54) when printing on the interposer.

3. The method according to Claim 2,
wherein the wafer is tested with regard to faulty regions before the interposer is printed on, and upon the basis of the test result the layout of the electrically conductive structures to be printed on is configured avoiding the faulty regions.

4. The method according to any of the preceding claims,
wherein the electrically conductive ink comprises metallic particles with a maximum dimension of at most 20 nm.

5. The method according to any of the preceding claims,
wherein the electrically conductive ink comprises silver, gold and/or copper particles.

6. The method according to any of the preceding claims,
wherein the electrically conductive ink comprises metallic particles which connect to one another at a temperature of below 200°C.

7. The method according to any of the preceding claims,
wherein the electrically conductive ink comprises metallic particles which connect to one another when irradiated with light having a wavelength of less than 600 nm.

8. The method according to any of Claims 2 to 7,
wherein the wafer is diced after printing on the interposer.

## Revendications

1. Procédé pour la fabrication d'un module semi-conducteur (10) avec au moins deux puces semi-conductrices (12, 16, 18) ainsi qu'un interposeur (20, 22, 24), lequel présente des structures électroconductrices (28) reliant ensemble les puces semi-conductrices, dans lequel :
- l'interposeur est imprimé directement sur une première des puces semi-conductrices,
- lors de l'impression de l'interposeur, les structures électroconductrices étant générées au moyen d'une encre à capacité électroconductrice (68),
- lors de l'impression de l'interposeur, une couche d'isolation électrique (31) avec des évidements (40) étant imprimée directement sur la première puce semi-conductrice par sérigraphie, et la génération des structures électroconductrices comprenant :
le remplissage des évidements au moyen de l'encre à capacité électroconductrice et la génération qui s'en suit de pistes conductrices par application de l'encre à capacité électroconductrice sur la couche d'isolation électrique, moyennant quoi l'encre à capacité électroconductrice est respectivement séparée au moyen d'un procédé d'impression par jet d'aérosol, ainsi que
- le montage de la deuxième puce semi-conductrice sur l'interposeur de telle sorte que les deux puces semi-conductrices sont disposées l'une au-dessus de l'autre et que l'interposeur forme une couche intermédiaire entre les deux puces semi-conductrices.

2. Procédé selon la revendication 1, dans lequel la première puce semi-conductrice est une partie d'une tranche de silicium (54) lors de l'impression de l'interposeur.

3. Procédé selon la revendication 2, dans lequel, avant l'impression de l'interposeur, la tranche de silicium est testée concernant des zones défectueuses, et sur la base du résultat du test, la conformation des structures électroconductrices à imprimer étant configurée en évitant les zones défectueuses.

4. Procédé selon l'une des revendications précédentes, dans lequel l'encre à capacité électroconductrice présente des particules métalliques avec une dimension maximale de 20 nm tout au plus.

5. Procédé selon l'une des revendications précédentes, dans lequel l'encre à capacité électroconductrice présente de l'argent, de l'or et/ou des particules de cuivre.

6. Procédé selon l'une des revendications précédentes, dans lequel l'encre à capacité électroconductrice présente des particules métalliques qui se lient à une température inférieure à 200°C.

7. Procédé selon l'une des revendications précédentes, dans lequel l'encre à capacité électroconductrice présente des particules métalliques qui se lient en cas d'une irradiation de lumière avec une longueur d'onde de moins de 600 nm.

8. Procédé selon l'une des revendications 2 à 7, dans lequel la tranche de silicium est séparée après l'impression de l'interposeur.
